(19) Europäisches Patentamt / European Patent Office / Office européen des brevets

(11) **EP 1 763 134 B1**

(12) **EUROPÄISCHE PATENTSCHRIFT**

(45) Veröffentlichungstag und Bekanntmachung des Hinweises auf die Patenterteilung:
**11.11.2015 Patentblatt 2015/46**

(51) Int Cl.:
*H03H 17/04* (2006.01)   *H03H 17/06* (2006.01)
*H03H 17/02* (2006.01)

(21) Anmeldenummer: **06018464.5**

(22) Anmeldetag: **04.09.2006**

(54) **Dezimierendes Filter und dezimierende Filterkaskade mit minimierter Einschwingzeit**

Decimating filter and decimating filter cascade with minimized settling time

Filtre à décimation et cascade de filtres à décimation à temps de stabilisation réduit au minimum

(84) Benannte Vertragsstaaten:
**DE FR GB**

(30) Priorität: **09.09.2005 DE 102005043011**

(43) Veröffentlichungstag der Anmeldung:
**14.03.2007 Patentblatt 2007/11**

(73) Patentinhaber: **Rohde & Schwarz GmbH & Co. KG**
**81671 München (DE)**

(72) Erfinder:
- **Reinhold, Michael**
  **81929 München (DE)**
- **Nitsch, Bernhard**
  **81825 München (DE)**

(74) Vertreter: **Körfer, Thomas et al**
**Mitscherlich PartmbB**
**Patent- und Rechtsanwälte**
**Postfach 33 06 09**
**80066 München (DE)**

(56) Entgegenhaltungen:
**EP-A2- 0 285 317   EP-A2- 0 427 377**

- **H. G. GÖCKLER; A. GROTH: "Multiratensysteme: Abtastratenumsetzung und digitale Filterbänke" 2004, J. SCHLEMBACH FACHVERLAG , GERMANY , XP002411008 * Seite 34 - Seite 37; Abbildungen 2.11,2.12 * * Seite 197 - Seite 204; Abbildungen 4.11,4.12 * * Seite 243 - Seite 259; Abbildungen 5.2(a),5.9(a) ***
- **S. CHU; C. S. BURRUS: "Optimum FIR and IIR Multistage Multirate Filter Design" CIRCUITS, SYSTEMS, AND SIGNAL PROCESSING, Bd. 2, Nr. 3, 1983, Seiten 361-386, XP002409259 USA**

**Beschreibung**

Die Erfindung betrifft eine dezimierende Filterkaskade mit minimierter Einschwingzeit.

In der digitalen Signalverarbeitung gibt es zahlreiche Anwendungen, in denen die Abtastfrequenz des abgetasteten Signals verringert werden muss. Hierzu werden dezimierende Filter eingesetzt, die sich in Transversal- und Polyphasenfilter unterteilen.

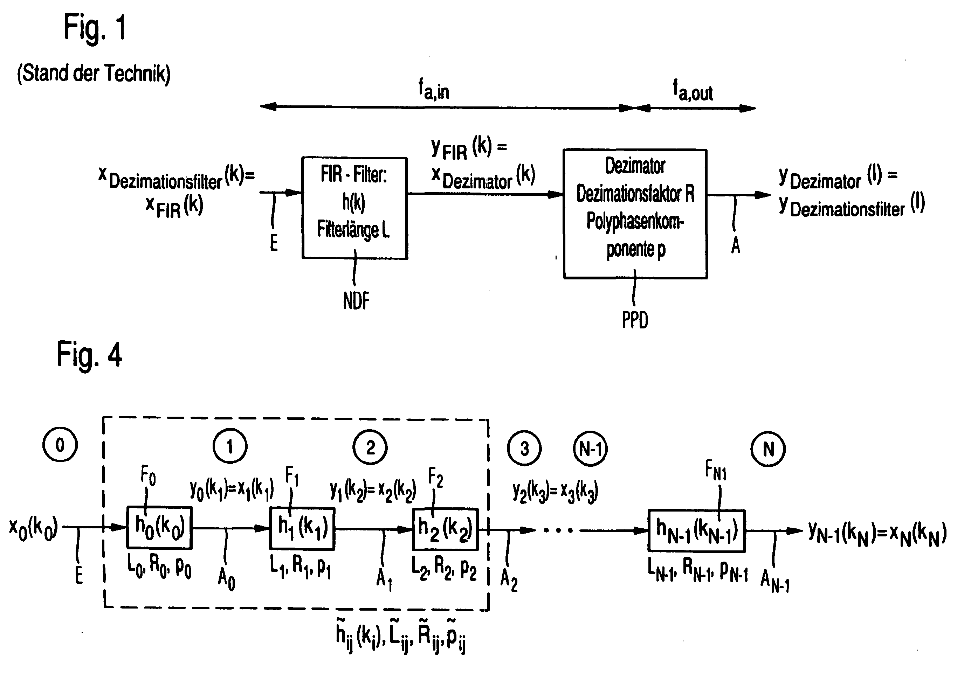

Reale Polyphasenfilter, die im folgenden betrachtet werden, können durch ein Ersatzschaltbild mit einer Serienschaltung aus einem nicht dezimierenden Filter NDF und einem idealen Dezimator PPD beschrieben werden. Gemäß Fig. 1 ist das nicht dezimierende Filter NDF als Finite-Impulse-Response-Filter (FIR-Filter) mit einer Übertragungsfunktion h(k) und einer Filterlänge L realisiert. Alternativ kann für das nicht dezimierende Filter auch ein Infinite-Impulse-Response-Filter (IIR-Filter) oder ein Cascaded-Integrator-Comb-Filter (CIC-Filter) eingesetzt werden. Der dazu in Serie geschaltete ideale Polyphasendezimator PPD führt eine Reduzierung der Abtastfrequenz $f_{a,in}$ seines Eingangssignals um einen

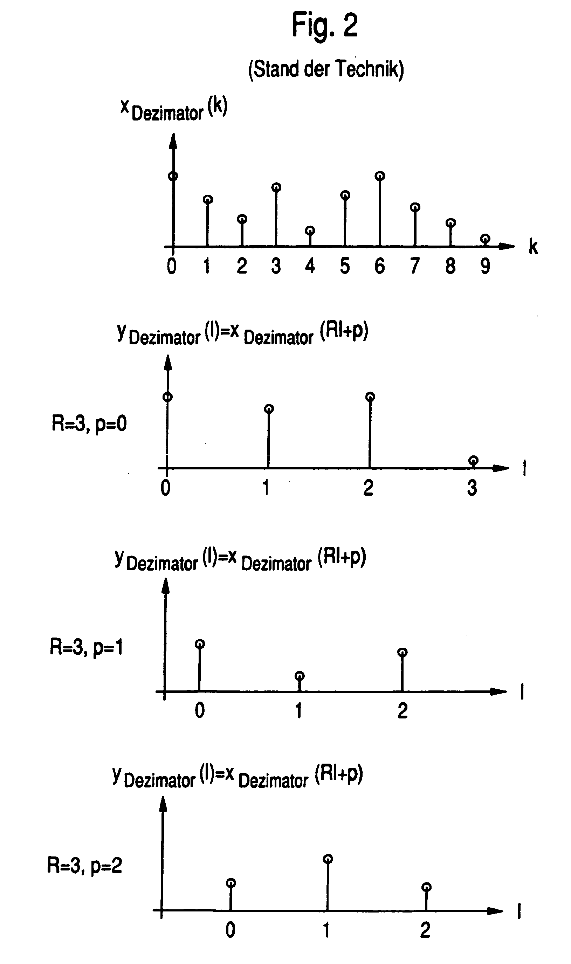

Dezimationsfaktor $R = \dfrac{f_{a,in}}{f_{a,out}}$ in eine Abtastfrequenz $f_{a,out}$ seines Ausgangssignals durch. Über die Polyphasenkomponente p wird vom idealen Polyphasendezimator PPD der Phasenversatz des Ausgangssignals gegenüber dem Eingangssignal in Anzahl von Abtastzeitpunkten eingestellt. Fig. 2 zeigt für ein gegebenes Eingangssignal $x_{Dezimator}(k)$ das von einem idealen Polyphasendezimator PPD erzeugte abtastratenreduzierte Ausgangssignal $y_{DEZIMATOR}(l)$ für einen Dezimationsfaktor R=3 und eine Polyphasenkomponente von p=0, p=1 und p=2.

Die Filterung des abgetasteten Eingangssignals in einem FIR-Filter NDF bewirkt, daß das resultierende Ausgangssignal aufgrund der Faltung des abgetasteten Eingangssignals mit der Übertragungsfunktion h(k) des FIR-Filters NDF erst nach einer bestimmten Anzahl von Abtastzeitpunkten einen "korrekten Wert" aufweist und somit eingeschwungen ist. Dieser Einschwingvorgang ist nach insgesamt L-1 Abtastzeitpunkten abgeschlossen, wobei L die Filterlänge des FIR-Filters NDF ist. Durch die Kombination des FIR-Filters NDF mit dem idealen Polyphasendezimator PPD ergibt sich, wie weiter unten noch im Detail gezeigt wird, eine weitere Verschlechterung des Einschwingvorgangs.

Aus H.G. Göckler et al. "Multiratensysteme: Abtastratenumsetzung und digitale Filterbänke", 2004, J. Schlembach Fachverlag, sowie aus S. Chu et al. "Optimum FIR and IIR Multistage Multirate Filter Design", Circuits, Systems and Signal Processing, Bd. 2, Nr. 3, 1983, Seiten 361-366, geht jeweils die Systemtheorie von ein- und mehrstufigen Filterstrukturen mit jeweils einem nichtdezimierenden Filter und einem nachfolgenden Dezimator hervor.

Die EP 0 427 377 A2 offenbart eine konkrete technische Realisierung einer Filterkaskade aus mehreren Dezimationsfiltern.

Aus der EP 0 285 317 A2 geht eine Phasensynchronisierung zwischen der Eingangs- und der Ausgangsdatensequenz in jeweils einem digitalen Filter einer Filterkaskade hervor.

In der Spektrumanalyse kann nach einer Abwärtsmischung von der Zwischenfrequenz ins Basisband, einer Empfangsfilterung und einer starken Abtastratenreduzierung die minimale Bandbreite des sogenannten VIDEO-Filters abhängig von der Messung beispielsweise 1 Hz betragen, so daß die Abtastrate des Signals am Ausgang der Filterkaskade entsprechend niedrig ist. Insbesondere bei derart niedrigen Abtastraten des Signals am Ausgang der Filterkaskade kann die Messzeit durch eine optimale Wahl der Polyphasenkomponente verkürzt werden.

Aufgabe der Erfindung ist es deshalb, die Einschwingzeit einer dezimierenden Filterkaskade zu minimieren.

Die Aufgabe wird durch die Merkmale des Anspruchs 1 gelöst. Die abhängigen Ansprüche enthalten vorteilhafte Weiterbildungen der Erfindung.

Als Bedingung für eine minimierte Einschwingzeit des dezimierenden Filters beziehungsweise der dezimierenden Filterkaskade wird die Einschwingzeit eines FIR-Filters NDF herangezogen, die einer Anzahl von Abtastzeitpunkten des Ausgangssignals in Höhe der um 1 reduzierten Filterlänge L entspricht.

Handelt es sich um ein dezimierendes Filter, so ergibt sich erfindungsgemäß die Polyphasenkomponente p des idealen Polyphasendezimators PPD für eine minimale Einschwingzeit des dezimierenden Filters als Rest der Modulo-Division der um 1 reduzierten Filterlänge L durch den Dezimationsfaktor R. Bei einer derartigen Belegung der Polyphasenkomponente p kommt genau ein Abtastwert des Ausgangssignals des dezimierenden Filters auf denjenigen Abtastzeitpunkt des Eingangssignals des dezimierenden Filters zu liegen, der um insgesamt L-1 Abtastzeitpunkte vom Beginn der Anregung des dezimierenden Filters entfernt liegt und damit zum frühest möglichen Zeitpunkt eingeschwungen ist.

Liegt eine dezimierende Filterkaskade vor, so ergeben sich erfindungsgemäß die Polyphasenkomponenten der einzelnen Polyphasendezimatoren PPD der dezimierenden Filterkaskade aus der Betrachtung, dass jeweils genau ein Abtastwert aller Abtastwerte des am Ausgang des jeweiligen Polyphasendezimators PPD anliegenden Ausgangssignals auf denjenigen Abtastzeitpunkt des Eingangssignals der dezimierenden Filterkaskade zu liegen kommt, der um eine Anzahl von Abtastzeitpunkten vom Beginn der Anregung der dezimierenden Filterkaskade entfernt liegt, die genau der um 1 reduzierten Filterlänge $\tilde{L}$ der gesamten dezimierenden Filterkaskade entspricht. Bei einer derartigen Festlegung der Polyphasenkomponente aller Polyphasendezimatoren PPD der dezimierende Filterkaskade sind erfindungsgemäß sämtliche Ausgangssignale der in der dezimierenden Filterkaskasdade seriell verschalteten dezimierenden Filter frühestmöglich eingeschwungen.

Neben einer rein seriellen Anordnung der einzelnen dezimierenden Filter in einer dezimierenden Filterkaskade gibt es auch Anwendungen von dezimierenden Filterkaskaden, in denen die einzelnen dezimierenden Filter sowohl seriell wie auch parallel zueinander angeordnet sind. Aufgrund der seriellen und parallelen Verschaltung der einzelnen dezimierenden Filter sind mehrere Eingänge $E_1$, $E_2$,... und Ausgänge $A_1$, $A_2$,... und sind damit mehrere Filterpfade zwischen jeweils einem Eingang und einem Ausgang in einer derartigen dezimierenden Filterkaskade ausgebildet. Um ein minimales Einschwingen jedes Filterpfades der dezimierenden Filterkaskade zu verwirklichen, müssen die einzelnen Polyphasenkomponenten p der einzelnen dezimierenden Filter des jeweiligen Filterpfades analog wie im Fall einer rein seriellen Verschaltung der einzelnen dezimierenden Filter in einer dezimierenden Filterkaskade ausgelegt werden.

Ausführungsbeispiele des erfindungsgemäßen dezimierenden Filters und der erfindungsgemäßen dezimierenden Filterkaskade werden im folgenden unter Berücksichtigung der Zeichnung näher erläutert. In der Zeichnung zeigen:

Fig. 1    ein Ersatzschaltbild für ein dezimierendes Filter,

Fig. 2    eine Zeitdiagramm des Eingangs- und Ausgangssignals eines idealen Polyphasendezimators für verschiedene Polyphasenkomponenten p,

Fig. 3    ein Zeitdiagramm des Eingangs-, Zwischen- und Ausgangssignals eines dezimierenden Filters nach dem Stand der Technik und eines erfindungsgemäßen dezimierenden Filters,

Fig. 4    ein Ersatzschaltbild einer ersten Ausführungsform einer dezimierenden Filterkaskade,

Fig. 5    ein Zeitdiagramm des Eingangs-, Zwischen- und Ausgangssignal einer erfindungsgemäßen dezimierenden Filterkaskade und

Fig. 6    ein Ersatzschaltbild einer zweiten Ausführungsform einer dezimierenden Filterkaskade.

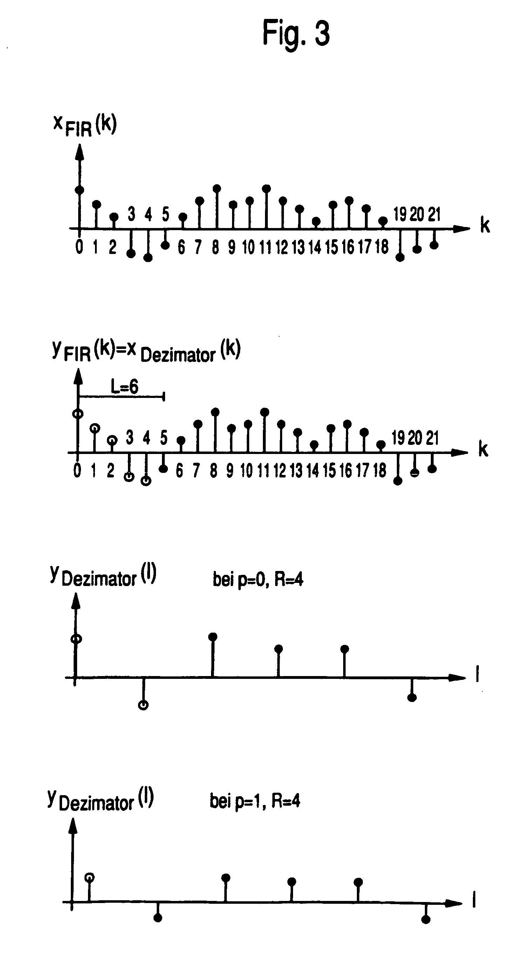

Anhand der Zeitdiagramme von Fig. 3 werden im folgenden die Zusammenhänge für die Auslegung eines erfindungsgemäßen dezimierenden Filters mit minimaler Einschwingzeit erläutert.

Das dezimierende Filter wird gemäß Fig. 1 und Fig. 3, Zeile 1, an seinem Eingang E mit einem abgetasteten Eingangssignal $x_{Dezimationsfilter}$ (k) beaufschlagt, das zugleich das Eingangssignal $x_{FIR}$(k) des nicht dezimierenden FIR-Filters NDF ist. Das FIR-Filter NDF weist eine Filterlänge L von 6 auf, so daß das abgetastete Ausgangssignal $y_{FIR}$(k), das gleichzeitig das abgetastete Eingangssignal $x_{Dezimator}$(k) des idealen Polyphasendezimators PPD ist, nach insgesamt L-1=5 Abtastzeitpunkten seit Anregung des FIR-Filters NDF mit dem abgetasteten Eingangssignal $x_{FIR}$(k) eingeschwungen ist. Der eingeschwungene Zustand des abgetasteten Ausgangssignals $y_{FIR}$(k) des FIR-Filters NDF für Abtastzeitpunkte $k \geq L$-1=5 wird in Fig. 3, Zeile 2, durch einen ausgefüllten Abtastwert gekennzeichnet, während die noch nicht eingeschwungenen Abtastwerte $y_{FIR}$(k) des Ausgangssignals des FIR-Filters NDF für Abtastzeiten $k < L$ - 1 = 5 durch einen nicht-ausgefüllten Abtastwert dargestellt werden.

Das Ausgangssignal $y_{Dezimator}$(l) des idealen Polyphasendezimators PPD, dessen Laufindex $l$ die reduzierte Abtastrate $f_{a,out}$ anzeigt, ist gleichzeitig auch das Ausgangssignal $y_{Dezimationsfilter}$(l) des dezimierenden Filters. Der ideale Polyphasendezimator PPD generiert aus seinem abgetasteten Eingangssignal $x_{Dezimator}$(l) entsprechend Gleichung (1) mittels der einstellbaren Polyphasenkomponente p und des einstellbaren Dezimationsfaktors R ein abtastratenreduziertes Ausgangssignal $y_{Dezimator}$(l).

$$y_{Dezimator}\left(l\right) = x_{Dezimator}\left(l \cdot R + p\right) \qquad (1)$$

Die Einstellung des Dezimationsfaktors R ergibt, wie weiter oben schon dargestellt, die Höhe der Abtastratenreduzierung zwischen Abtastrate $f_{a,in}$ des Eingangssignals $x_{Dezimator}$(l) und Abtastrate $f_{a,out}$ des Ausgangssignals $y_{Dezimator}$(l).

Die Einstellung der Polyphasenkomponente p, die entsprechend der Bedingung in Gleichung (2) erfolgt, bestimmt, zu welchem Zeitpunkt das abgetastete Ausgangssignal $y_{Dezimator}$(l) relativ zum abgetasteten Eingangssignal $x_{Dezimator}$(l) erzugt wird:

$$0 \leq p \leq R - 1 \qquad (2)$$

Der *l*-te Abtastwert des Ausgangssignals $y_{Dezimator}(l)$ erscheint bei gegebenen Dezimationsfaktor R und gegebener Polyphasenkomponente p zum gemäß Gleichung (3) berechneten Abtastzeitpunkt k am Ausgang des idealen Polyphasendezimators PPD.

$$k = l \cdot R + p \qquad (3)$$

Wird für einen nicht-optimierten Einschwingvorgang des dezimierenden Filters der Dezimationsfaktor $R = 4$ und die Polyphasenkomponente $p = 0$ gewählt, so erscheint der erste eingeschwungene Wert des abgetasteten Ausgangssignals $y_{Dezimator}(l)$ des idealen Polyphasendezimators PPD zum Zeitpunkt $k = 8$ (Fig. 3, Zeile 3). Bei optimaler Wahl der Polyphasenkomponente $p = 1$ erhält man bereits bei $k = 5$ am Ausgang des idealen Polyphasendezimators PPD einen eingeschwungenen Ausgangswert (Fig. 3, Zeile 4). Dies entspricht der durch die Filterlänge $L = 6$ des FIR-Filters NDF festgelegten minimalen Einschwingzeit des FIR-Filters NDF.
Als Optimalitätskriterium muß folglich ausgehend von Gleichung (3) die Bedingung in Gleichung (4) erfüllt sein.

$$k = L - 1 = l \cdot R + p \qquad (4)$$

Dieses Optimalitätskriterium für minimiertes Einschwingverhalten eines dezimierenden Filters impliziert die in Gleichung (5) dargestellte Berechnungsvorschrift für die Polyphasenkomponente $P$:

$$p = \mathrm{MOD}\{L - 1, R\} \qquad (5)$$

Somit erhält man zum frühest möglichen Zeitpunkt $k = L - 1$ einen eingeschwungenen Ausgangswert am Ausgang A des dezimierenden Filters. Bei einem IIR- oder CIC-Filter verwendet man in Gleichung (3) anstelle der Filterlänge L die entsprechende systemtheoretische Ersatzlänge $\tilde{L}_{IIR}$ bzw. $\tilde{L}_{CIC}$.
Ausgehend von Gleichung (2) beträgt der Zeitgewinn $\Delta t$ bei optimaler Wahl der Polyphasenkomponente $P$ im Vergleich zur ungünstigsten Wahl der Polyphasenkomponente $P$ gemäß Gleichung (6):

$$\Delta t = \frac{R - 1}{f_{a,in}} \qquad (6)$$

Besteht die Signalverarbeitungskette nicht nur aus einem einzigen dezimierenden Filter, sondern gemäß der ersten Ausführungsform der Erfindung aus mehreren in Reihe geschalteten dezimierenden Filtern, so muß die in Gleichung (5) dargestellte Einstellungsvorschrift für die Polyphasenkomponente p des idealen Polyphasendezimators PPD für die optimale Einstellung der Polyphasenkomponente $p_i$ der einzelnen Polyphasendezimatoren PPD$_i$ der Filterkaskade erweitert werden, wie im folgenden hergeleitet wird.
Gemäß Fig. 4 besteht die dezimierende. Filterkaskade aus insgesamt N dezimierenden Filtern F$_0$, F$_1$, F$_2$,..., F$_{N-1}$, welche jeweils - ohne die in Fig. 1 dargestellte gedankliche Trennung in ein nicht dezimierendes FIR-Filter NDF und einen idealen Polyphasendezimator PPD - eine Übertragungsfunktion $h_i(k_i)$, eine Filterlänge $L_i$, einen Dezimationsfaktor $R_i$ und eine Polyphasenkomponente $p_i$ aufweisen. Das dezimierende Filter F$_i$ erzeugt ein Ausgangssignal $y_i(k_j)$, dessen Index $k_j$ zur Abtastrate $f_{a,j}$ korrespondiert, aus einem Eingangssignal $x_i(k_i)$, dessen Index $k_i$ zur gegenüber der Abtastrate $f_{a,j}$ höheren Abtastrate $f_{a,j}$ korrespondiert. Für ein nicht dezimierendes Filter NDF gilt in dieser Schreibweise $R_i = 1$ und $p_i = 0$.
Die dezimierenden Filter F$_i$,...,F$_{j-1}$ zwischen den Ebenen *i* und *j* - in Fig. 4 sei $i = 0$ und $j = 3$ gewählt - können durch ein dezimierendes Ersatzfilter mit der Übertragungsfunktion $\tilde{h}_{ij}(k_i)$, der Filterlänge $\tilde{L}_{ij}$, dem Dezimationsfaktor $\tilde{R}_{ij}$ sowie der Polyphasenkomponente $\tilde{p}_{ij}$ ersetzt werden. Die Ersatzgrößen $\tilde{h}_{ij}(k_i)$, $\tilde{L}_{ij}$, $\tilde{R}_{ij}$ und $\tilde{p}_{ij}$ berechnen sich wie folgt:
Für den Dezimationsfaktor $\tilde{R}_{ij}$ des dezimierenden Ersatzfilters gilt die Berechnungsvorschrift in Gleichung (7), wobei $R_\xi$ der Dezimationsfaktor des dezimierenden Filters F$_\xi$ ist:

$$\tilde{R}_{ij} = \prod_{\xi=i}^{j-1} R_{\xi} \quad \text{mit} \quad \tilde{R}_{ii} = 1 \tag{7}$$

.

Für die Polyphasenkomponente $\tilde{p}_{ij}$ des dezimierenden Ersatzfilters gilt die Berechnungsvorschrift in Gleichung (8), wobei $p_{\xi}$ die Polyphasenkomponente des dezimierenden Filters $F_{\xi}$ ist:

$$\tilde{p}_{ij} = \sum_{\xi=i}^{j-1} \tilde{R}_{i\xi} p_{\xi} \quad \text{mit} \quad \tilde{p}_{ii} = 0 \tag{8}$$

Um die Ersatzübertragungsfunktion $\tilde{h}_{ij}(k_i)$ zu berechnen, müssen zunächst die einzelnen Übertragungsfunktionen $h_{\xi}(k_{\xi})$ des jeweiligen dezimierenden Filters $F_{\xi}$ zwischen den Abtastebenen $i < \xi < j$ von der Ebene $\xi$ mit der Abtastfrequenz $f_{a,\xi}$ in die Ebene i mit der Abtastfrequenz $f_{a,j}$ transformiert werden. Eine auf die Ebene $i$ mit der Abtastfrequenz $f_{a,j}$ transformierte Übertragungsfunktion wird im folgenden mit $\tilde{h}_{\xi}(k_i)$ bezeichnet und hat gemäß Gleichung (9) die Eigenschaft:

$$\tilde{h}_{\xi}(k_i) = \begin{cases} h_{\xi}(k_{\xi}) & \text{für } k_i = \tilde{R}_{i\xi} \cdot k_{\xi} \\ 0 & \text{sonst} \end{cases} \tag{9}$$

Die transformierte Übertragungsfunktion $\tilde{h}_{\xi}(k_i)$ des dezimierenden Filters $F_{\xi}$ ergibt sich aus der ursprünglichen Übertragungsfunktion $h_{\xi}(k_{\xi})$ des dezimierenden Filters $F_{\xi}$, indem die transformierte Übertragungsfunktion $\tilde{h}_{\xi}(k_i)$ zwischen den einzelnen Abtastzeitpunkten $k_i = \tilde{R}_{i\xi} \cdot k_{\xi}$ jeweils mit insgesamt $\tilde{R}_{i\xi}$-1 Nullen ergänzt wird.

Somit ergibt sich gemäß Gleichung (10) die Übertragungsfunktion $\tilde{h}_{ij}(k_i)$ des dezimierenden Ersatzfilters zwischen den Abtastebenen i und j aus einer Faltung der auf die Abtastregion $i$ transformierten Übertragungsfunktionen $\tilde{h}_{\xi}(k_i)$ der einzelnen dezimierenden Filter $F_{\xi}$ zwischen den Abtastebenen $i < \xi < j$:

$$\tilde{h}_{ij} = h_i(k_i) * \tilde{h}_{i+1}(k_i) * \ldots * \tilde{h}_{j-2}(k_{j-2}) * \tilde{h}_{j-1}(k_{j-1}) \tag{10}$$

Die Länge $\tilde{L}_{ij}$ des Ersatzfilters ergibt sich gemäß Gleichung (11) aus der Filterlänge $L_{\xi}$ des dezimierenden Filters $F_{\xi}$ und des Dezimationsfaktors $R_{i\xi}$ des dezimierenden Ersatzfilters zwischen der Abtastebene i und $\xi$:

$$\tilde{L}_{ij} = 1 + \sum_{\xi=i}^{j-1} \tilde{R}_{i\xi} \cdot (L_{\xi} - 1) \tag{11}$$

Der zeitliche Zusammenhang zwischen der Abtastregion $i$ und der Abtastregion $j$ lautet in Anlehnung an Gleichung (3) gemäß Gleichung (12):

$$k_i = k_j \cdot \tilde{R}_{ij} + \tilde{p}_{ij} \tag{12}$$

Analog zur minimalen Einschwingzeit eines einzelnen dezimierenden Filters $F_{\xi}$ in Höhe der um 1 reduzierten Filterlänge L des FIR-Filters NDF ergibt sich die minimale Einschwingzeit einer dezimierende Filterkaskade mit mehreren dezimierenden Filtern $F_i, \ldots, F_{j-1}$ zwischen den Abtastebenen i und j aus der um 1 reduzierten Filterlänge $\tilde{L}_{ij}$ des Ersatzfilters zwischen den Abtastebenen i und j. Folglich muß gemäß Gleichung (13) unter Berücksichtigung von Gleichung (11) zum Abtastzeitpunkt $k_i$ ein Abtastwert am Ausgang $A_i, \ldots, A_{j-1}$ der dezimierenden Filterkaskade $F_i, \ldots, F_{j-1}$ vorliegen, um ein minimales Einschwingen der dezimierenden Filterkaskade zu erzielen.

$$k_i = \tilde{L}_{ij} - 1 = \sum_{\xi=i}^{j-1} R_{i\xi} \cdot (L_{\xi} - 1) \tag{13}$$

Der Zeitgewinn $\Delta t$ bei optimaler Wahl der Polyphasenkomponenten einer dezimierenden Filterkaskade im Vergleich zur ungünstigsten Wahl der Polyphasenkomponenten einer dezimierenden Filterkaskade beträgt gemäß Glei-

chung (14):

$$\Delta t = \frac{R_{ij} - 1}{f_{a,j}} \tag{14}$$

Analog zum Optimalitätskriterium für minimiertes Einschwingverhalten eines dezimierenden Filters in Gleichung (5), muß für jedes dezimierende Filter $F_\xi$ einer dezimierenden Filterkaskade zwischen den Abtastebenen i und *j* ein in der Abtastebene $F_\xi$ zum Abtastzeitpunkt $k_\xi$ am Ausgang des dezimierenden Filters $F_\xi$ anliegender Abtastwert $y_{\xi-1}(k_\xi)$ des Ausgangssignals $y_{\xi-1}$ zum Abtastzeitpunkt $k_i = \tilde{L}_{ij} - 1$ in der Abtastebene i zu liegen kommen. Ausgehend von Gleichung (12) muß in Analogie zu Gleichung (12) für den Fall eines einzigen dezimierenden Filters das Optimalitätskriterium in Gleichung (15) erfüllt sein.

$$k_i = \tilde{L}_{ij} - 1 = k_\xi \cdot \tilde{R}_{i\xi} + \tilde{p}_{i\xi} \qquad \forall i < \xi \leq j \tag{15}$$

Dieses Optimalitätskriterium für minimiertes Einschwingverhalten einer dezimierenden Filterkaskade impliziert, daß der Abtastzeitpunkt $k_\xi$ des am Ausgang jedes dezimierenden Filters $F_\xi$ anliegenden Abtastwertes $y_{\xi-1}(k_\xi)$ des Ausgangssignals $y_{\xi-1}$ ganzzahlig sein muß und somit Gleichung (16) erfüllen muß:

$$\text{MOD} \left\{ k_i - \tilde{p}_{i\xi}, \tilde{R}_{i\xi} \right\} = 0 \qquad \forall i < \xi \leq j \tag{16}$$

Das Optimalitätskriterium in Gleichung (16) kann folgendermaßen umgeformt werden:

Hierzu wird Gleichung (8) mathematisch umgeformt nach Gleichung (17):

$$\tilde{p}_{ij} = \tilde{R}_{i,j-1} p_{j-1} + \sum_{\xi=i}^{j-2} \tilde{R}_{i\xi} p_\xi = \tilde{R}_{i,j-1} p_{j-1} + \tilde{p}_{i,j-1} \quad \text{mit} \quad \tilde{p}_{ii} = 0 \tag{17}$$

Wendet man die Erkenntnis aus Gleichung (17) im Optimalitätskriterium der Gleichung (16) an, so ergibt sich Gleichung (18):

$$\text{MOD}\left\{ k_i - \tilde{p}_{i,\xi-1} - \tilde{R}_{i,\xi-1} p_{\xi-1}, \tilde{R}_{i\xi} \right\} = 0 \qquad \forall i < \xi \leq j \tag{18}$$

Zur Vereinfachung wird Gleichung (18) in eine äquivalente Form gemäß Gleichung (19) umgeschrieben:

$$\text{MOD}\{A - bC, R\} = 0 \qquad \text{mit} \quad A = k_i - \tilde{p}_{i,\xi-1}; \quad b = \tilde{R}_{i,\xi-1}; \quad C = p_{\xi-1}; \quad R = \tilde{R}_{i\xi} \tag{19}$$

Gleichung (19) kann unter Einführung eines ganzzahligen Faktors $\lambda$ nach Gleichung (20) bzw. nach Gleichung (21) übergeführt werden:

$$A - bC - \lambda R = 0 \tag{20}$$

$$C = \frac{1}{b}(A - \lambda R) \tag{21}$$

Die rechte Seite von Gleichung (21) lässt sich wiederum als Modulo-Bedingung gemäß Gleichung (22) beschreiben:

$$C = \frac{1}{b} \cdot \mathrm{MOD}\{A, R\} \qquad\qquad (22)$$

Führt man in Gleichung (22) eine Resubstitution der Hilfsgrößen A, b, C und R aus Gleichung (19) durch, so erhält man Gleichung (23):

$$p_{\xi-1} = \frac{1}{\tilde{R}_{i,\xi-1}} \cdot \mathrm{MOD}\{k_i - \tilde{p}_{i,\xi-1}, \tilde{R}_{i\xi}\} \qquad \forall\, i < \xi \le j \qquad (23)$$

Nach Substitution von $\mu = \xi - 1$ in Gleichung (23) erhält man Gleichung (24):

$$p_\mu = \frac{1}{\tilde{R}_{i,\mu}} \cdot \mathrm{MOD}\{k_i - \tilde{p}_{i,\mu}, \tilde{R}_{i,\mu+1}\} \qquad \forall\, i \le \mu < j \qquad (24)$$

Mit Hilfe von Gleichung (24) lassen sich die einzelnen Polyphasenfaktoren $p_\mu$ der einzelnen dezimierenden Filter $F_\mu$ der dezimierenden Filterkaskade iterativ beginnend mit $\mu = i$ berechnen.

Eine dezimierende Filterkaskade aus beispielsweise drei dezimierenden Filtern sei gegeben. Zum Zeitpunkt $k_0 = \tilde{L}_{03} - 1$ soll eine dezimierende Filterkaskade eingeschwungen sein. Die einzelnen Polyphasenkomponenten $p_0, ..., p_2$ der drei dezimierenden Filter lassen sich gemäß Gleichung (24a), (24b) und (24c) bestimmen:

$$p_0 = \frac{1}{\tilde{R}_{00}} \cdot \mathrm{MOD}\{k_0 - \tilde{p}_{00}, \tilde{R}_{01}\} = \mathrm{MOD}\{k_0, R_0\} \qquad (24a)$$

$$p_1 = \frac{1}{\tilde{R}_{01}} \cdot \mathrm{MOD}\{k_0 - \tilde{p}_{01}, \tilde{R}_{02}\} = \frac{1}{R_0} \cdot \mathrm{MOD}\{k_0 - p_0, R_0 R_1\} \qquad (24b)$$

$$p_2 = \frac{1}{\tilde{R}_{02}} \cdot \mathrm{MOD}\{k_0 - \tilde{p}_{02}, \tilde{R}_{03}\} = \frac{1}{R_0 R_1} \cdot \mathrm{MOD}\{k_0 - p_0 - p_1 R_0, R_0 R_1 R_2\} \;(24c)$$

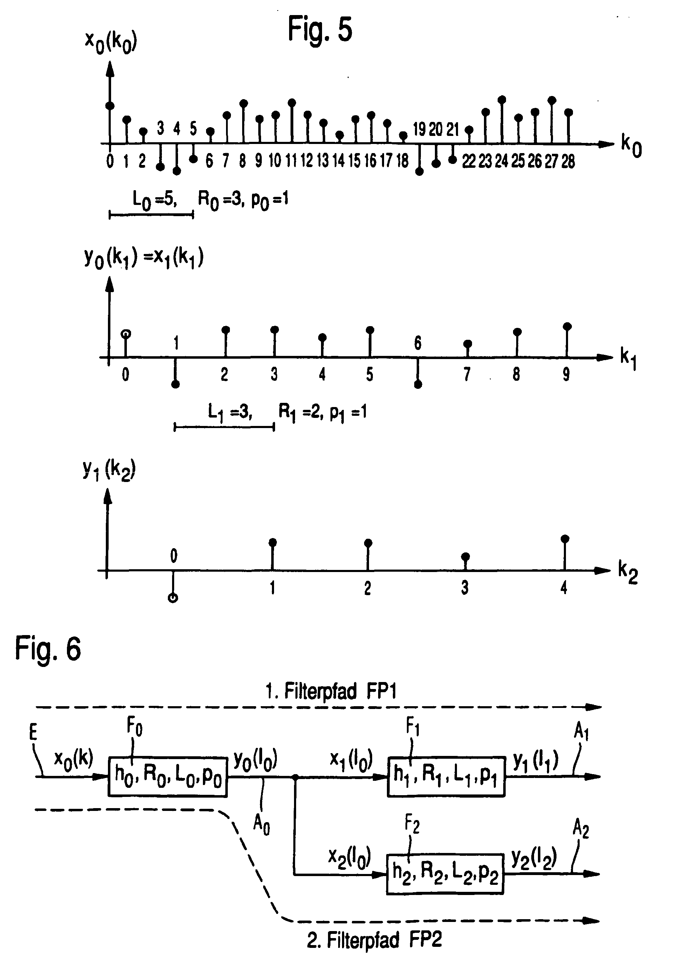

Das Zeitdiagramm in Fig. 5 zeigt für eine erste Ausführungsform einer dezimierenden Filterkaskade aus zwei seriell verschalteten dezimierenden Filtern in Zeile 1 ein abgetastetes Eingangssignal $x_0(k_0)$, in Zeile 2 das abgetastete Ausgangssignal $y_0(k_1)$ am Ausgang des ersten dezimierenden Filters und in Zeile 3 das abgetastete Ausgangssignal $y_1(k_2)$ am Ausgang des zweiten dezimierenden Filters.

In Fig. 5 ist zu erkennen, daß in Zeile 2 mit der Wahl der Polyphasenkomponente $p_0$ des ersten dezimierenden Filters $F_0$ ($p_0 = 1$) gemäß Gleichung (24a) ($p_0 = \mathrm{MOD}\{k_0 = L_0 - 1, R_0\} = \mathrm{MOD}\{4, 3\}$) ein zeitoptimales Einschwingen des ersten dezimierenden Filters $F_0$ zum Abtastzeitpunkt $k_0 = L_0 - 1 = 4$ erzielt wird. Aus Zeile 3 der Fig. 5 ist außerdem zu erkennen, daß mit der Wahl der Polyphasenkomponente $p_1$ des zweiten dezimierenden Filters $F_1$ ($p_1 = 1$) gemäß Gleichung (24b)

$$p_1 = \frac{1}{R_0} \cdot \mathrm{MOD}\{k_0 - p_0, R_0 R_1\} = \frac{1}{3} \cdot \mathrm{MOD}\{4 - 1, 3 \cdot 2\} \quad \text{ebenfalls ein zeitoptimales Einschwingen des}$$

zweiten dezimierenden Filters $F_1$ zum Abtastzeitpunkt $k_0 = \tilde{L}_{02} - 1 = 10$ gemäß Gleichung (12) bei einer Filterlänge $\tilde{L}_{02} = 11$ der dezimierenden Filterkaskade gemäß Gleichung (11) erreicht wird.

Bei einer zweiten Ausführungsform einer erfindungsgemäßen Filterkaskade gemäß Fig. 6 sind die einzelnen dezimierenden Filter nicht nur seriell, sondern auch parallel geschaltet. Beispielsweise bildet sich in der dezimierenden Filterkaskade der Fig. 6 auf diese Weise zwischen dem Eingang E und einem ersten Ausgang $A_1$ der dezimierenden Filterkaskade ein erster Filterpfad $FP_1$ mit dem dezimierenden Filter $F_0$ und dem dazu seriell verschalteten dezimierenden Filter $F_1$ und ein zweiter Filterpfad $FP_2$ mit dem dezimierenden Filter $F_0$ und dem dezimierenden Filter $2$ $F_2$.

Für die Bestimmung optimierter Polyphasenkomponenten in den einzelnen dezimierenden Filtern $F_0, F_1, F_2$ sind die einzelnen Filterpfade $FP_1, FP_2$ als serielle Verschaltung mehrerer dezimierender Filter $F_0, F_1, F_2$ zu betrachten und in analoger Weise wie in der ersten Ausführungsform einer erfindungsgemäßen dezimierenden Filterkaskade vorzugehen. Auf diese Weise kann insbesondere sicher gestellt werden, dass zu gleichen Zeitpunkten in beiden Filterpfaden $FP_1$, $FP_2$ Ausgangssignale erzeugt werden.

Die Erfindung ist nicht auf die dargestellten Ausführungsformen beschränkt. Insbesondere sind außer der in Fig. 6 dargestellten Filterstruktur auch andere Filterstrukturen einer dezimierenden Filterkaskade von der Erfindung abgedeckt. Liegen variabel programmierbare Filterlängen der einzelnen dezimierenden Filter vor, so ist eine frei programmierbare Berechnung der einzelnen Polyphasenkomponenten von der Erfindung ebenfalls abgedeckt.

**Patentansprüche**

1. Filterkaskade mit mindestens einem Filterpfad ($FP_1$;$FP_2$) bestehend aus jeweils mindestens einem dezimierenden Filter ($F_0$, $F_1$, $F_2$, .. , $F_\mu$, . , $F_{N-1}$), welches sich aus einem nicht dezimierenden Filter (NDF) in Serie zu einem Polyphasendezimator (PPD) zur Reduzierung einer Abtastfrequenz $f_{ain}$ seines Eingangssignals $X_{Dezimator}$ (k) in eine Abtastfrequenz $f_{aout}$ seines Ausgangsignals $Y_{Dezimator}$ (k) und zur Einstellung eines Phasenversatzes seines Ausgangssignals $Y_{Dezimator}$ (k) gegenüber seinem Eingangsignal $X_{Dezimator}$ (k) zusammensetzt,
   **dadurch gekennzeichnet,**
   **dass** für das dezimierende Filter ($F_\mu$) zwischen den Abtastebenen $\mu$ und $\mu$+1 die Polyphasenkomponente $p_\mu$ des zugehörigen Polyphasendezimators (PPD) mit einem zu einem Moduluswert $MOD\{\tilde{L}_{i,u-1}\tilde{p}_{i,u},\tilde{R}_{i,u+1}\}$ proportionalen Wert eingestellt ist, wobei bei der Berechnung des Moduluswerts als Dividend die Differenz zwischen einer um 1 reduzierten Filterlänge $\tilde{L}_{i,\mu}$ und einer Polyphasenkomponente $\tilde{p}_{i,\mu}$ eines die zwischen der Abtastebene $i$=0 am Eingang (E) der Filterkaskade und der Abtastebene $\mu$ befindlichen nicht dezimierenden Filtern (NDF) und Polyphasendezimatoren (PPD) ersetzenden Ersatzfilters und als Divisor ein Dezimationsfaktor $\tilde{R}_{i,\mu+1}$ eines die zwischen der Abtastebene $i$=0 am Eingang (E) der Filterkaskade und der Abtastebene $\mu$+1 befindlichen nicht dezimierenden Filtern (NDF) und Polyphasendezimatoren (PPD) ersetzenden Ersatzfilters verwendet wird.

2. Filterkaskade nach Anspruch 1,
   **dadurch gekennzeichnet,**
   **dass** sich die Filterlänge $\tilde{L}_{i,j}$ des Ersatzfilters aus den zwischen dem in der Abtastebene $i$ befindlichen Eingang (E) und einem in der Abtastebene $j$ befindlichen Ausgang ($A_1$;$A_2$) des jeweiligen Filterpfads ($FP_1$;$FP_2$) seriell geschalteten nicht dezimierenden Filtern (NDF) und Polyphasendezimatoren (PPD) aus Filterlängen $L_\mu$ der im jeweiligen Filterpfad ($FP_1$;$FP_2$) jeweils geschalteten nicht dezimierenden Filter (NDF) gemäß folgender Formel ergibt:

$$\widetilde{L}_{i,j} = 1 + \sum_{\xi=i}^{j-1} \widetilde{R}_{i,\xi} \cdot \left( L_\xi - 1 \right)$$

   wobei $\tilde{R}_{i,\xi}$ der Dezimationsfaktor des Ersatzfilters zwischen den Abtastebenen $i$ und $\xi$ ist,
   wobei der Dezimationsfaktor $\tilde{R}_{i,\xi}$ zwischen den Abtastebenen $i$ und $\xi$ gemäß folgender Formel bestimmt ist:

$$\widetilde{R}_{i,\xi} = \prod_{\lambda=i}^{\xi-1} R_\lambda \quad \text{mit} \quad \widetilde{R}_{i,i} = 1$$

   wobei $R_\lambda$ der Dezimationsfaktor eines $\lambda$-ten Polyphasenfilters ab dem Eingang (E) des Filterpfades ($FP_1$;$FP_2$) ist und
   wobei $L_\xi$ die Filterlänge eines $\xi$-ten dezimierenden Filters $F_\xi$ ab dem Eingang (E) eines Filterpfads ($FP_1$,-$FP_2$) ist.

3. Filterkaskade nach Anspruch 1 oder 2,
   **dadurch gekennzeichnet,**
   **dass** die Polyphasenkomponente $p_v$ des $v$-ten Polyphasendezimators eines Filterpfades ($FP_1$; $FP_2$) ab dem Eingang (E) des Filterpfades sich iterativ aus der Polyphasenkomponente $p_\mu$ aller zwischen der Abtastebene $i$=0 am Eingang (E) des Filterpfads ($FP_1$;$FP_2$) und der Abtastebene $v$ befindlichen Polyphasendezimatoren gemäß folgender Formel ergibt:

$$p_v = \frac{1}{\prod_{\xi=i}^{v-1} R_\xi} \cdot MOD\left\{ \tilde{L}_{i,v} - 1 - \sum_{\mu=i}^{v-1}\left(\prod_{\xi=i}^{\mu-1} R_\xi\right) \cdot p_\mu, \prod_{\xi=i}^{v} R_\xi \right\}$$

wobei $R_\xi$ der Dezimationsfaktor eines $\xi$-ten Polyphasendezimators ab dem Eingang des Filterpfads ist,
wobei $\tilde{L}_{i,v}$ die Filterlänge des Ersatzfilter zwischen den Abtastebenen $i$=0 und der Abtastebene $v$ ist und
wobei $MOD\{\cdot\}$ die Modulo-Funktion ist.

4. Filterkaskade nach einem der Ansprüche 1 bis 3,
   **dadurch gekennzeichnet,**
   **dass** das nicht dezimierende Filter (NDF) ein Finite-Impulse-Response-Filter FIR, ein Infinite-Impulse- FIR Response-Filter IIR oder ein Cascaded-Integrator-Comb-Filter CIC ist.

**Claims**

1. Filter cascade with at least one filter path (FP$_1$; FP$_2$) consisting of in each case at least one decimating filter (F$_0$, F$_1$, F$_2$, .., $F_\mu$, .., F$_{N-1}$), which is composed of a non-decimating filter (NDF) in series with a polyphase decimator (PPD) for reducing a sampling frequency f$_{ain}$ of its input signal X$_{Decimator}$ (k) to a sampling frequency f$_{aout}$ of its output signal Y$_{Decimator}$ (k) and for setting a phase shift of its output signal Y$_{Decimator}$ (k) with respect to its input signal X$_{Decimator}$ (k),
   **characterised in that**
   for the decimating filter $(F_\mu)$ between the sampling levels $\mu$ and $\mu$+1 the polyphase component $p_\mu$ of the associated polyphase decimator (PPD) is set with a value which is proportional to a modulus value MOD$\{\tilde{L}_{i,\mu}$-1-$\tilde{p}_{i,\mu}, \tilde{R}_{i,\mu+1}\}$, wherein for the calculation of the modulus value the dividend used is the difference between a filter length $\tilde{L}_{i,\mu}$ reduced by 1 and a polyphase component $\tilde{P}_{i,u}$ of a substitute filter replacing the non-decimating filters (NDF) and polyphase decimators (PPD) located between the sampling level $i$=0 at the input (E) of the filter cascade and the sampling level $\mu$ and the divisor used is a decimation factor $\tilde{R}_{i,u+1}$ of a substitute filter replacing the non-decimating filters (NDF) and polyphase decimators (PPD) located between the sampling level $i$=0 at the input (E) of the filter cascade and the sampling level $\mu$ + 1.

2. Filter cascade according to claim 1,
   **characterised in that**
   the filter length $\tilde{L}_{i,j}$ of the substitute filter is obtained from the non-decimating filters (NDF) and polyphase decimators (PPD) connected in series between the input (E) located in the sampling level $i$ and an output (A1; A2) of the respective filter path (FP1; FP2) located in the sampling level $j$ from filter lengths $L_\mu$ of the non-decimating filters (NDF) connected in each case in the respective filter path (FP$_1$; FP$_2$) according to the following formula:

$$\tilde{L}_{i,j} = 1 + \sum_{\xi=i}^{j-1} \tilde{R}_{i,\xi} \cdot \left( L_\xi - 1 \right)$$

wherein $\tilde{R}_{i,\xi}$ is the decimation factor of the substitute filter between the sampling levels $i$ and $\xi$,
wherein the decimation factor $\tilde{R}_{i,\xi}$ between the sampling levels $i$ and $\xi$ is determined according to the following formula:

$$\tilde{R}_{i,\xi} = \prod_{\lambda=i}^{\xi-1} R_\lambda \quad \text{in which} \quad \tilde{R}_{i,i} = 1$$

wherein $R_\lambda$ is the decimation factor of a $\lambda$ th polyphase filter from the input (E) of the filter path (FP$_1$; FP$_2$) and
wherein $L_\xi$ is the filter length of an $\xi$ th decimating filter $F_\xi$ from the input (E) of a filter path (FP$_1$; FP$_2$).

3. Filter cascade according to claim 1 or 2,
**characterised in that**
the polyphase component $p_v$ of the $v$ th polyphase decimator of a filter path (FP$_1$; FP$_2$) from the input (E) of the filter path is obtained iteratively from the polyphase component $p_\mu$ of all the polyphase decimators located between the sampling level $i$=0 at the input (E) of the filter path (FP$_1$; FP$_2$) and the sampling level $v$ according to the following formula:

$$p_v = \frac{1}{\prod_{\xi=i}^{v-1} R_\xi} \cdot MOD\left\{ \tilde{L}_{i,v} - 1 - \sum_{\mu=i}^{v-1}\left(\prod_{\xi=i}^{\mu-1} R_\xi\right)\cdot p_\mu, \prod_{\xi=i}^{v} R_\xi \right\}$$

wherein $R_\xi$ is the decimation factor of an $\xi$ th polyphase decimator from the input of the filter path,
wherein $\tilde{L}_{i,v}$ is the filter length of the substitute filter between the sampling levels $i$=0 and the sampling level $v$ and
wherein $MOD\{\cdot\}$ is the modulo function.

4. Filter cascade according to one of claims 1 to 3,
**characterised in that**
the non-decimating filter (NDF) is a finite impulse response filter FIR, an infinite impulse response filter IIR or a cascaded integrator comb filter CIC.

**Revendications**

1. Cascade de filtres comportant au moins un trajet de filtre (FP$_1$ ; FP$_2$) comportant respectivement au moins un filtre à décimation (F$_0$, F$_1$, F$_2$, ..., F$_\mu$, ..., F$_{N-1}$), qui est constitué d'un filtre à non décimation (NDF) en série avec un décimateur polyphasé (PPD) en vue de la réduction d'une fréquence d'échantillonnage f$_{ain}$ de son signal d'entrée X$_{Dezimator}$ (k) dans une fréquence d'échantillonnage f$_{aout}$ de son signal de sortie y$_{Dezimator}$ (k) et en vue du réglage d'un déphasage de son signal de sortie y$_{Dezimator}$ (k) par rapport à son signal d'entrée X$_{Dezimator}$ (k),
**caractérisée en ce que**
la composante polyphasée p$_\mu$ du décimateur polyphasé associé (PPD) est réglée respectivement entre les plages d'échantillonnage u et $\mu$+1 avec une valeur proportionnelle à une valeur modulo $MOD\{\tilde{L}_{i,\mu} - 1 - \tilde{p}_{i,\mu}, \tilde{R}_{i,\mu+1}\}$ pour le filtre à décimation (F$\mu$) entre les plages d'échantillonnage $\mu$ et $\mu$+1, où, lors du calcul de la valeur modulo, la différence entre une longueur de filtre réduite à 1 $\tilde{L}_{i,\mu}$ et une composante polyphasée $\tilde{p}_{i,\mu}$ d'un filtre de remplacement remplaçant les filtres à non décimation (NDF) et les décimateurs polyphasés (PPD) se trouvant entre la plage d'échantillonnage i=0 à l'entrée (E) de la cascade de filtres et la plage d'échantillonnage $\mu$ est utilisée en tant que dividende et un facteur de décimation $\tilde{R}_{i,\mu+1}$ d'un filtre de remplacement remplaçant les filtres à non décimation (NDF) et les décimateurs polyphasés (PPD) se trouvant entre la plage d'échantillonnage i=0 à l'entrée (E) de la cascade de filtres et la plage d'échantillonnage $\mu$+1 est utilisé en tant que diviseur.

2. Cascade de filtres selon la revendication 1, caractér isée en ce que
la longueur de filtre $\tilde{L}_{i,j}$ du filtre de remplacement est déterminée à partir des filtres à non décimation (NDF) et des décimateurs polyphasés (PPD) montés en série entre l'entrée (E) se trouvant dans la plage d'échantillonnage i et une sortie (A$_1$ ; A$_2$) se trouvant dans la plage d'échantillonnage j du trajet de filtre respectif (FP$_1$ ; FP$_2$) à partir des longueurs de filtre L$_\mu$ des filtres à non décimation (NDF) montés respectivement dans le trajet de filtre respectif (FP$_1$ ; FP$_2$) selon la formule suivante :

$$\tilde{L}_{i,j} = 1 + \sum_{\xi=i}^{j-1} \tilde{R}_{i,\xi} \cdot (L_\xi - 1)$$

où $\tilde{R}_{i,\xi}$ est le facteur de décimation du filtre de remplacement entre les plages d'échantillonnage i et $\xi$,
où le facteur de décimation $\tilde{R}_{i,\xi}$ entre les plages d'échantillonnage i et $\xi$ est déterminé selon la formule suivante :

$$\tilde{R}_{i,\xi} = \prod_{\lambda=i}^{\xi-1} R_\lambda \quad \text{avec} \quad \tilde{R}_{i,i} = 1$$

où $R_\lambda$ est le facteur de décimation d'un $\lambda$-ième filtre polyphasé à partir de l'entrée (E) du trajet de filtre (FP$_1$ ; FP$_2$) et où $L_\xi$ est la longueur de filtre d'un $\xi$-ième filtre à décimation $F_\xi$ à partir de l'entrée (E) d'un trajet de filtre (FP$_1$ ; FP$_2$).

3. Cascade de filtres selon la revendication 1 ou 2, caractérisée en ce que

la composante polyphasée $p_v$ du v-ième décimateur polyphasé d'un trajet de filtre (FP$_1$ ; FP$_2$) est déterminée à partir de l'entrée (E) du trajet de filtre de manière itérative à partir de la composante polyphasée $p_\mu$ de tous les décimateurs polyphasés se trouvant entre la plage d'échantillonnage i=0 à l'entrée (E) du trajet de filtre (FP$_1$ ; FP$_2$) et la plage d'échantillonnage v à partir de la formule suivante :

$$p_v = \frac{1}{\prod_{\xi=i}^{v-1} R_\xi} \cdot MOD\left\{ \tilde{L}_{i,v} - 1 - \sum_{\mu=i}^{v-1}\left(\prod_{\xi=i}^{\mu-1} R_\xi\right) p_\mu, \prod_{\xi=i}^{v} R_\xi \right\}$$

où $R_\xi$ est le facteur de décimation d'un $\xi$-ième décimateur polyphasé à partir de l'entrée du trajet de filtre,
où $\tilde{L}_{i,v}$ est la longueur de filtre du filtre de remplacement entre la plage échantillonnage i=0 et la plage d'échantillonnage $v$ et
où MOD{·} est la fonction modulo.

4. Cascade de filtres selon l'une des revendications 1 à 3,
**caractérisée en ce que**
le filtre à non décimation (NDF) est un filtre à réponse impulsionnelle finie FIR, un filtre à réponse impulsionnelle infinie IIR ou un filtre en peigne intégrateur en cascade CIC.

Fig. 1
(Stand der Technik)

Fig. 4

# Fig. 2

## (Stand der Technik)

$x_{\text{Dezimator}}(k)$

$y_{\text{Dezimator}}(l) = x_{\text{Dezimator}}(Rl+p)$

R=3, p=0

$y_{\text{Dezimator}}(l) = x_{\text{Dezimator}}(Rl+p)$

R=3, p=1

$y_{\text{Dezimator}}(l) = x_{\text{Dezimator}}(Rl+p)$

R=3, p=2

# Fig. 3

$x_{FIR}(k)$

$y_{FIR}(k) = x_{Dezimator}(k)$

L=6

$y_{Dezimator}(l)$       bei p=0, R=4

$y_{Dezimator}(l)$       bei p=1, R=4

## Fig. 5

$x_0(k_0)$

$L_0 = 5, \quad R_0 = 3, \ p_0 = 1$

$y_0(k_1) = x_1(k_1)$

$L_1 = 3, \quad R_1 = 2, \ p_1 = 1$

$y_1(k_2)$

## Fig. 6

1. Filterpfad FP1

E

$x_0(k)$

$F_0$

| $h_0, R_0, L_0, p_0$ |

$y_0(l_0)$

$A_0$

$x_1(l_0)$

$F_1$

| $h_1, R_1, L_1, p_1$ |

$y_1(l_1)$

$A_1$

$x_2(l_0)$

$F_2$

| $h_2, R_2, L_2, p_2$ |

$y_2(l_2)$

$A_2$

2. Filterpfad FP2

**IN DER BESCHREIBUNG AUFGEFÜHRTE DOKUMENTE**

**In der Beschreibung aufgeführte Patentdokumente**

- EP 0427377 A2

- EP 0285317 A2

**In der Beschreibung aufgeführte Nicht-Patentliteratur**

- Multiratensysteme: Abtastratenumsetzung und digitale Filterbänke. **H.G. GÖCKLER et al.** J. Schlembach. Fachverlag, 2004

- **S. CHU et al.** Optimum FIR and IIR Multistage Multirate Filter Design. *Circuits, Systems and Signal Processing,* 1983, vol. 2 (3), 361-366